(19) Europäisches Patentamt
European Patent Office
Office européen des brevets

(11) EP 2 023 169 A1

(12) **EUROPEAN PATENT APPLICATION**
published in accordance with Art. 153(4) EPC

(43) Date of publication:
**11.02.2009 Bulletin 2009/07**

(21) Application number: **07741209.6**

(22) Date of filing: **06.04.2007**

(51) Int Cl.:
***G02B 5/30*** (2006.01) ***G02F 1/1335*** (2006.01)

(86) International application number:
**PCT/JP2007/057773**

(87) International publication number:
**WO 2007/116972 (18.10.2007 Gazette 2007/42)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **07.04.2006 JP 2006106134**

(71) Applicant: **Asahi Glass Company, Limited**
**Chiyoda-ku**
**Tokyo 100-8405 (JP)**

(72) Inventors:
- **KAIDA, Yuriko**
  **Tokyo 100-8405 (JP)**
- **SAKAMOTO, Hiroshi**
  **Tokyo 100-8405 (JP)**
- **SAKURAI, Hiromi**
  **Tokyo 100-8405 (JP)**
- **KAWAGUCHI, Yasuhide**
  **Tokyo 100-8405 (JP)**
- **ASAKAWA, Akihiko**
  **Tokyo 100-8405 (JP)**
- **NIWANO, Kazuhiko**
  **Tokyo 100-8405 (JP)**

(74) Representative: **Perrey, Ralf et al**
**Müller-Boré & Partner,**
**Grafinger Strasse 2**
**81671 München (DE)**

(54) **WIRE GRID POLARIZER AND METHOD FOR PRODUCING THE SAME**

(57) The present invention provides a wire-grid polarizer showing high polarization separation ability in the visible light region and is excellent in heat resistance and durability; and a process for producing such a wire-grid polarizer with high productivity, which enables to produce a polarizer of large area.

A process for producing a wire-grid polarizer, comprising a step of coating a supporting substrate with a photocurable composition, a step of pressing a mold having a plurality of parallel grooves at a constant pitch against the photocurable composition so that the grooves contact with the photocurable composition, a step of curing the photocurable composition in a state that the mold is pressed against the photocurable composition, to form a light-transmitting substrate having a plurality of ridges corresponding to the grooves of the mold, a step of separating the mold from the light-transmitting substrate, and a step of forming fine metalic wires on the ridges of the light-transmitting substrate.

Fig.2(a)

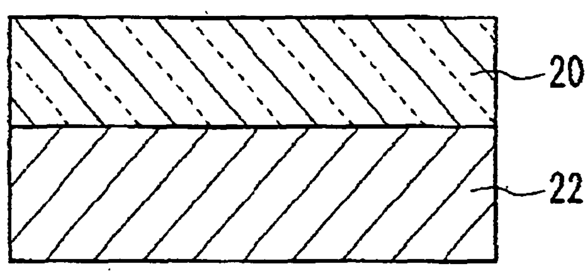


EP 2 023 169 A1

Fig.2(b)

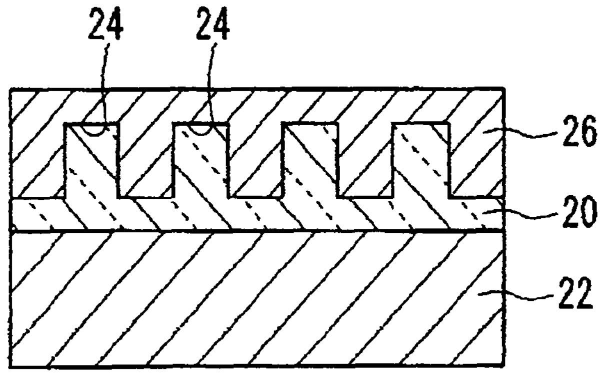


Fig.2(c)

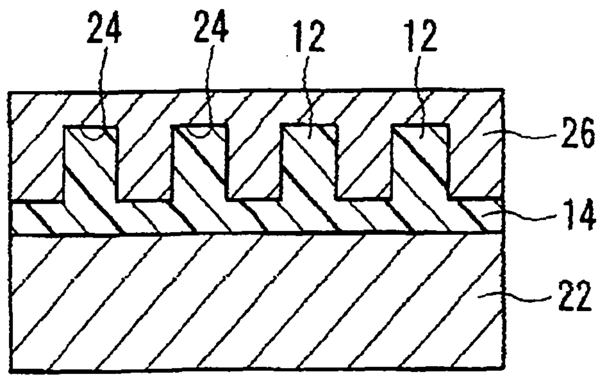

## Description

TECHNICAL FIELD

The present invention relates to a wire-grid polarizer and a process for producing the polarizer.

BACKGROUND ART

As a polarizer used for image display devices such as liquid crystal display devices, projection TVs or front projectors, and showing polarization separation ability in the visible light region, there are absorption polarizers and reflection polarizers.

An absorption polarizer is, for example, a polarizer having a dual-color dye such as iodine aligned in a resin film. However, since such an absorption polarizer absorbs one of polarized light, its light-utilization efficiency is low.

On the other hand, in a reflection polarizer, reflected light not incident into the polarizer is incident again into the polarizer, whereby light-utilization efficiency can be improved. For this reason, demand for such a reflection polarizer for the purpose of achieving high intensity of e.g. liquid crystal display devices, is increased.

As a reflection polarizer, there are a linear polarizer constituted by a lamination of birefringent resins, a circular polarizer constituted by a cholesteric liquid crystal and a wire-grid polarizer.

However, since such linear polarizers and circular polarizers have low polarization separation ability. For this reason, a wire-grid polarizer showing high polarization separation ability is attentioned.

A wire-grid polarizer has a construction comprising a transparent substrate having a plurality of parallel fine metalic wires arranged on the substrate.

When the pitch of the fine metalic wires is sufficiently shorter than the wavelength of incident light, in incident light, a component (i.e. P polarized light) having an electric field vector perpendicular to the fine metalic wires is transmitted, but a component (i.e. S polarized light) having an electric field vector parallel with the fine metalic wires is reflected.

As wire-grid polarizers showing polarization separation ability in visible light region, the following types are known.

(1) A wire-grid polarizer in which a plurality of parallel fine metalic wires arranged on a glass substrate (Patent Document 1).
(2) A wire-grid polarizer in which a plurality of parallel fine metalic wires are arranged on a resin film (Patent Documents 2 and 3).
(3) A wire-grid polarizer in which fine metalic wires are formed in a plurality of grooves formed in a resin layer (Patent Document 4).

However, since the wire-grid polarizers of (1) and (2) are produced by patterning a metal vapor-deposition film on a substrate, by a photolithography method using DUV (deep ultraviolet light) of wavelength 193 nm, there are many production steps and there are problems in productivity and areal size of the polarizer.

Further, in the wire-grid polarizer of (2), when a thermoplastic resin is employed as a resin film, there are problems in heat resistance and durability. In e.g. rear projection TVs or front projectors etc., along with increase of light source energy to achieve high intensity, the polarizer is expected to be used at a temperature higher than the softening point of resin, and the polarizer is required to have heat resistance.

In the wire-grid polarizer of (3), fine metalic wires are formed on ridges of resin. In the pattern forming step, a thermal imprint method or a UV imprint method is used, but an etching step is required after the imprint step. Further, when a thermoplastic resin is used as a resin layer, there are problems in heat resistance and durability.

Patent Document 1: WO00/079317

Patent Document 2: JP-A-2005-195824

Patent Document 3: JP-A-2005-316495

Patent Document 4: JP-A-2005-070456

DISCLOSURE OF THE INVENTION

PROBLEMS TO BE SOLVED BY THE INVENTION

The present invention provides a wire-grid polarizer having high polarization separation ability in visible light region, and excellent in heat resistance and durability, and a process for producing such a wire-grid polarizer with good productivity, which enables large area size of the polarizer.

MEANS FOR SOLVING THE PROBLEMS

The process for producing a wire-grid polarizer of the present invention comprises a step of coating a supporting substrate with a photocurable composition, a step of pressing a mold having a plurality of parallel grooves at a constant pitch against the photocurable composition so that the grooves contact with the photocurable composition, a step of curing the photocurable composition in a state that the mold is pressed against the photocurable composition, to form a light-transmitting substrate having a plurality of ridges corresponding to the grooves of the mold, a step of separating the mold from the light-transmitting substrate, and a step of forming fine metalic wires on the ridges of the light-transmitting substrate.

The process for producing a wire-grid polarizer of the present invention may further comprises a step of separating a supporting substrate from the light-transmitting substrate.

As the photocurable composition, it is preferred to employ one producing the following photocured resin having the following physical properties after curing:

a photocured resin having a refractive index (nd) of from 1.3 to 1.6, a visible light transmittance of at least 93% when the thickness is 200 μm. Further, a photocured resin having a contact angle with water of at least 90˚. Further, a photocured resin having a Vicat softening temperature of at least 150˚C.

As the photocurable composition, the following photocurable composition is preferably employed:

a photocurable composition containing from 50 to 98 mass% of monomer containing no fluorine atom, from 0.1 to 45 mass% of fluorine-containing monomer, from more than 0.1 to 20 mass% of a fluorine-containing surfactant and/or a fluorine-containing polymer, and from 1 to 10 mass% of a photo-polymerization initiator, which contains substantially no solvent, and which has a viscosity of from 1 to 200 mPa·s at 25˚C.

As the fluorine-containing monomer of the photocurable composition, fluorine-containing monomer represented by the following formula (1) or (2) is preferred:

$$CF_2=CR^1\text{-}Q\text{-}CR^2=CH_2 \qquad (1)$$

$$(CH_2=CXCOO)_nR^F \qquad (2)$$

wherein in formula (1), $R^1$ and $R^2$ are each independently a hydrogen atom, a fluorine atom, an alkyl group containing 1 to 3 carbon atoms, or a fluoroalkyl group containing from 1 to 3 carbon atoms, and Q is an oxygen atom, a group represented by $-NR^3-$ (wherein $R^3$ is a hydrogen atom, an alkyl group containing 1 to 6 carbon atoms, an alkylcarbonyl group or a tosyl group), or a divalent organic group that may have a functional group; and
wherein in formula (2), n is an integer of from 1 to 4, X is a hydrogen atom, a fluorine atom, a methyl group or a trifluoromethyl group, and $R^F$ is a n-valent fluorine-containing organic group containing from 1 to 30 carbon atoms.

As the step of forming fine metalic wires on the ridges of the light-transmitting substrate, an oblique deposition method is preferably employed.

The pitch of the grooves of the mold is preferably at most 300 nm.

The wire-grid polarizer of the present invention is one produced by the process for producing a wire-grid polarizer of the present invention.

EFFECTS OF THE INVENTION

The wire-grid polarizer of the present invention shows high polarization separation ability in the visible light region, and is excellent in heat resistance and durability.

According to the process for producing a wire-grid polarizer of the present invention, a wire-grid polarizer showing high polarization separation ability in the visible light region and excellent in heat resistance and durability can

be produced with good productivity, and the process enables large area size of the polarizer.

BRIEF EXPLANATION OF THE DRAWINGS

Fig. 1: An oblique view showing an example of a wire-grid polarizer of the present invention.
Figs. 2(a) to 2(c): Cross sectional views showing steps in the process for producing a wire-grid polarizer of the present invention.
Figs. 3(d) to 3(f): Cross sectional views showing steps in the process for producing a wire-grid polarizer of the present invention.
Fig. 4: An oblique view showing an example of a mold to be employed for the process for producing a wire-grid polarizer of the present invention.
Fig. 5: A graph showing transmittances of P-polarized light and S-polarized light vs. incident light wavelength, and polarization degree of transmission light vs. incident light wavelength in the wire-grid polarizer of the present invention at an incident angle $\theta = 0^\circ$.
Fig. 6: A graph showing transmittances of P-polarized light and S-polarized light vs. incident light wavelength, and polarization degree of transmission light vs. incident light wavelength in the wire-grid polarizer of the present invention at an incident angle $\theta - 45^\circ$.

EXPLANATION OF NUMERALS

10: Wire-grid polarizer
12: Ridge
14: Light-transmitting substrate
16: Fine metalic wire
20: Photocurable composition
22: Supporting substrate
24: Groove
26: Mold

BEST MODE FOR CARRYING OUT THE INVENTION

In this specification, a monomer represented by formula (1) is described as monomer (1). Monomers represented by other formulas are also described in the same manner.

WIRE-GRID POLARIZER

Fig. 1 is an oblique view showing an example of a wire-grid polarizer of the present invention. A wire-grid polarizer 10 has a light-transmitting substrate 14 made of a photocured resin having a surface on which a plurality of parallel ridges 12 are formed.at a constant pitch Pp, and fine metalic wires 16 formed on the ridges 12 on the light-transmitting substrate 14.
The pitch Pp of the ridges 12 is the total of a width Dp of a ridge 12 and a width of a groove formed between the ridges 12. The pitch Pp of ridges 12 is preferably at most 300 nm, more preferably from 50 to 200 nm. By making the pitch Pp at most 300 nm, the wire-grid polarizer 10 shows sufficiently high reflectivity, and shows a high polarization separation ability even in a short wavelength region of about 400 nm. Further, coloring effect due to diffraction can be suppressed.
A ratio (Dp/Pp) of the width Dp to the pitch Pp of the ridge 12 is preferably from 0.1 to 0.6, more preferably from 0.4 to 0.55. By making Dp/Pp at least 0.1, the polarization separation ability of the wire-grid polarizer 10 becomes sufficiently high. By making Dp/Pp at most 0.6, coloring of transmission light due to interference can be suppressed.
The height Hp of the ridge 12 is preferably from 50 to 500 nm, more preferably from 100 to 300 nm. By making the height Hp at least 50 nm, selective forming of fine metalic wires 16 on the ridges 12 becomes easy. By making the height Hp at most 500 nm, incident angle dependence of polarization degree of the wire-grid polarizer 10 becomes small.
The width Dm of the fine metalic wire 16 is preferably the same as the width Dp of the ridge 12.
The height Hm of the fine metalic wire 16 is preferably from 30 to 300 nm, more preferably from 100 to 150 nm. By making the height Hm at least 30 nm, the wire-grid polarizer 10 shows sufficiently high reflectivity and polarization

separation ability. By making the height Hm at most 300 nm, light utilization efficiency increases.

LIGHT-TRANSMITTING SUBSTRATE

A light-transmitting substrate is a substrate made of a photocured resin. The light-transmitting means a characteristic that it transmits light.
The thickness H of the light-transmitting substrate is preferably from 0.5 to 1,000 μm, more preferably from 1 to 40 μm.
The photocured resin is preferably a resin formed by photo-radical polymerization of a photocurable composition from the viewpoint of productivity.
The refractive index (nd) of the photocured resin is preferably from 1.3 to 1.6. By making the reflectivity (nd) at most 1.6, the transmittance for P-polarized light in a blue light region increases, and the polarizer shows high polarization separation ability in a wide wavelength range.
The refractive index (nd) is measured with respect to a photocured resin film of 10 μm thick by using an Abbe refractive index meter (589 nm, 25˚C).
The visible light transmittance of the photocured resin is preferably at least 93% when the thickness is 200 μm. By making the visible light transmittance at least 93%, the transmittance for P-polarized light becomes high and the polarization separation ability becomes high. The visible light transmittance is measured by using an integration type light transmittance meter and obtained by calculating the ratio ($T2 \times 100/T1$) between total light amount T1 in a range of from 400 nm to 800 nm and a sample transmission light T2.
The contact angle of the photocured resin with water is preferably at least 90˚. When the contact angle with water is at least 90˚, mold separation property improves at a time of forming ridges by a photo imprint method to be described later, which enables transcription with high precision and to obtain a wire-grid polarizer that sufficiently exhibits objective performance.
The contact angle with water is measured by using a contact angle measurement apparatus.
The Vicat softening temperature of the photocured resin is preferably at least 150˚C. When the Vicat softening temperature is at least 150˚C, its heat resistance improves, and the resin becomes sufficiently usable for an application requiring heat resistance.
A Vicat softening temperature is obtained according to JIS K 7206.
A photocured resin satisfying the above characteristics may, for example, be a resin produced by curing the following photocurable composition by photopolymerization.
A photocurable composition containing from 50 to 98 mass% of monomer containing no fluorine atom, from 0.1 to 45 mass% of fluorine-containing monomer, from more than 0.1 to 20 mass% of fluorine-containing surfactant and/or fluorine-containing polymer, and from 1 to 10 mass% of photopolymerization initiator, and containing substantially no solvent, which has a viscosity of from 1 to 200 mPa·s at 25˚C.
By using the above composition, it becomes possible to improve smoothness at a time of coating, mold-separation property at a time of photo imprint, and shape-retention property.
The viscosity of the photocurable composition is preferably from 1 to 200 mPa·s, more preferably from 1 to 100 mPa·s. When the viscosity is in this range, a smooth coating film can be easily produced by a method such as spin coating.
The viscosity is measured at 25˚C by using a rotation type viscosity meter.
The photocurable composition contains a monomer (hereinafter referred to as main component monomer) containing no fluorine atom in an amount of from 50 to 98 mass%, preferably from 55 to 90 mass%, particularly preferably from 60 to 85 mass%.
The main component monomer may be a monomer having a polymerizable group, and is preferably a monomer having an acryloyl group or a methacryloyl group, a monomer having a vinyl group, a monomer having an allyl group or a monomer having an oxiranyl group, more preferably a monomer having an acryloyl group or a methacryloyl group.
The number of polymerizable groups in the main component monomer is preferably from 1 to 4, more preferably 1 or 2, particularly preferably 1.
The main component monomer is preferably (meth)acrylic acid, (meth)acrylate, (meth)acrylamide, vinyl ether, vinyl ester, allyl ether, allyl ester or a styrene type compound, particularly preferably (meth)acrylate. (Meth)acrylic acid is a generic name of acrylic acid and methacrylic acid, (meth)acrylate is a generic name of acrylate and methacrylate, (meth)acrylamide is a generic name of acrylamide and methacrylamide.
Specific examples of (meth)acrylate may be the following compounds.
A mono(meth)acrylate such as phenoxyethyl (meth)acrylate, benzyl (meth)acrylate, stearyl (meth)acrylate, lauryl (meth)acrylate, 2-ethylhexyl (meth)acrylate, ethoxyethyl (meth)acrylate, methoxyethyl (meth)acrylate, glycidyl (meth)acrylate, tetrahydrofurfuryl (meth)acrylate, allyl (meth)acrylate, 2-hydroxyethyl (meth)acrylate, 2-hydroxypropyl (meth)acrylate, N,N-diethylaminoethyl (meth)acrylate, N,N-dimethylaminoethyl (meth)acrylate, dimethylaminoethyl

(meth)acrylate, methyladamantyl (meth)acrylate, ethyladamantyl (meth)acrylate, hydroxyadamantyl (meth)acrylate, adamantyl (meth)acrylate or isobornyl (meth)acrylate.

A di(meth)acrylate such as 1,3-butanediol di(meth)acrylate, 1,4-butanediol di(meth)acrylate, 1,6-hexanediol di(meth)acrylate, diethylene glycol di(meth)acrylate, triethylene glycol di(meth)acrylate, tetraethylene glycol di(meth) acrylate, neopentyl glycol di(meth)acrylate, polyoxyethylene glycol di(meth)acrylate or tripropylene glycol di(meth)acrylate.

A tri(meth)acrylate such as trimethylolpropane tri(meth)acrylate or pentaerythritol tri(meth)acrylate.

A (meth)acrylate having at least four polymerizable groups such as dipentaerythritol hexa(meth)acrylate.

A specific example of vinyl ether may be an alkyl vinyl ether such as ethyl vinyl ether, propyl vinyl ether, isobutyl vinyl ether, 2-ethylhexyl vinyl ether or cyclohexyl vinyl ether, or a (hydroxyalkyl)vinyl such as 4-hydroxybutyl vinyl ether.

A specific example of vinyl ester may be a vinyl ester such as vinyl acetate, vinyl propionate, (iso)vinyl lactate, vinyl valerate, vinyl cyclohexane carboxylate or vinyl benzoate.

A specific example of allyl ether may be an alkyl allyl ether such as ethyl allyl ether, propyl allyl ether, (iso)butyl allyl ether or cyclohexyl allyl ether.

A specific example of allyl ester may be an alkyl allyl ester such as ethyl allyl ester, propyl allyl ester, or isobutyl allyl ester.

A monomer having an oxiranyl group may be a monomer having an epoxy group, a monomer having an oxetane group or a monomer having an oxazoline group.

The molecular weight of the main component monomer is preferably from 100 to 500, more preferably from 200 to 400. One type of the main component monomer may be used alone, or at least two types of main component monomers may be used in combination.

The main component monomer preferably contains a monomer having the following cycle structure in its molecule for the reason that the photocured resin exhibits high visible light transmittance.

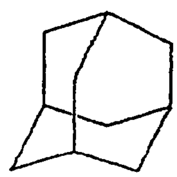

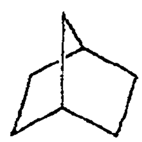

The main component monomer preferably contains a (meth)acrylate having at least two polymerizable groups in order to exhibit high heat resistance. Specifically, such a (meth)acrylate may, for example, be 1,3-butanediol diacrylate, 1,4-butanediol diacrylate, 1,6-hexanediol diacrylate, trimethylolpropane triacrylate, pentaerythritol triacrylate, dipentaerythritol hexaacrylate, diethylene glycol diacrylate, neopentyl glycol diacrylate, polyoxyethylene glycol diacrylate or tripropylene glycol diacrylate.

The photocurable composition contains a fluorine-containing monomer in an amount of from 0.1 to 45 mass%, preferably from 10 to 40 mass%.

The photocurable composition contains a fluorine-containing monomer having high compatibility with the main component monomer, the fluorine-containing surfactant and the fluorine-containing polymer, and thus, the composition hardly undergoes phase separation. Further, the composition tends to form a cured product without undergoing phase separation. Further, since the composition contains a fluorine-containing monomer, its cured product has a contact angle with water of at least 90˚. Further, since the composition contains a fluorine-containing monomer, its cured product has low refractive index and high transmittance in a short wavelength region, and as a result, it has high polarization separation ability.

The fluorine-containing monomer is a fluorine-containing monomer having a polymerizable group, and is preferably a fluorine-containing monomer having an acryloyl group or a methacryloyl group, a fluorine-containing monomer having a vinyl group, a fluorine-containing monomer having a fluorovinyl group, a fluorine-containing monomer having an allyl group or a fluorine-containing monomer having an oxiranyl group.

The number of polymerizable groups in the fluorine-containing monomer is preferably 1 to 4, more preferably 1 or 2, particularly preferably 1.

The fluorine content of the fluorine-containing monomer is preferably from 40 to 70 mass%, more preferably from 45 to 65 mass%. The fluorine content is a ratio of the mass of fluorine atoms based on the total mass of all atoms constituting the fluorine-containing monomer. By making the fluorine content of the fluorine-containing monomer at least 40 mass%, the mold-separation property of the cured product becomes especially excellent. By making the fluorine content of the fluorine-containing monomer at most 70 mass%, its compatibility with the photopolymerization initiator improves, and it becomes easy to uniformly prepare the photocurable composition.

The molecular weight of the fluorine-containing monomer is preferably from 200 to 5,000, more preferably from 250 to 1,000.

One type of the fluorine-containing monomer may be used alone, or at least two types of the fluorine-containing monomers may be used in combination.

The fluorine-containing monomer is particularly preferably the following monomer (1) or monomer (2):

$CF_2=CR^1\text{-}Q\text{-}CR^2=CH_2$ (1)

$(CH_2=CXCOO)_nR^F$ (2)

Here, symbols in the formulas have the following meanings.

In monomer (1), $R^1$ and $R^2$ are each independently a hydrogen atom, a fluorine atom, an alkyl group containing from 1 to 3 carbon atoms, or a fluoroalkyl group containing from 1 to 3 carbon atoms, and Q is an oxygen atom, a group represented by $-NR^3-$ (wherein $R^3$ is a hydrogen atom, an alkyl group containing from 1 to 6 carbon atoms, an alkylcarbonyl group or a tosyl group), or a divalent organic group that may have a functional group.

In monomer (2), n is an integer of from 1 to 4, X is a hydrogen atom, a fluorine atom, a methyl group or a trifluoromethyl group, and $R^F$ is a n-valent fluorine-containing organic group containing from 1 to 30 carbon atoms.

When Q in monomer (1) is a divalent organic group, Q has, as its main chain, a group selected from the group consisting of methylene, dimethylene, trimethylene, tetramethylene, oxymethylene, oxydimethylene, oxytrimethylene and dioxymethylene, wherein a hydrogen atom in the main chain is substituted by a group selected from the group consisting of a fluorine atom, a hydroxyl group, an alkyl group containing from 1 to 6 carbon atoms, a hydroxyalkyl group containing from 1 to 6 carbon atoms, an alkyl group containing from 1 to 6 carbon atoms wherein an ether type oxygen atom is inserted between carbon atoms, and a hydroxyalkyl group containing from 1 to 6 carbon atoms wherein an ether type oxygen atom is inserted between carbon atoms; wherein at least one hydrogen atom constituting a carbon atom-hydrogen atom bond in the group is substituted by a fluorine atom. Q is particularly preferably $-CF_2C(CF_3)(OH)CH_2-$, $-CF_2C(CF_3)(OH)-$, $-CF_2C(CF_3)(OCH_2OCH_3)CH_2-$, $-CH_2CH(CH_2C(CF_3)_2OH)CH_2-$ or $-CH_2CH(CH_2C(CF_3)_2OH)-$. Here, the direction of each group indicates that its left side is connected to $CF_2=CR^1-$.

Specific examples of monomer (1) are the following compounds:

$CF_2=CFCH_2CH(C(CF_3)_2OH)CH_2CH=CH_2$,

$CF_2=CFCH_2CH(C(CF_3)_2OH)\ CH=CH_2$,

$CF_2=CFCH_2CH(C(CF_3)_2OH)CH_2CH_2CH=CH_2$,

$CF_2=CFCH_2CH(CH_2C(CF_3)_2OH)CH_2CH_2CH=CH_2$,

$CF_2=CFCH_2C(CH_3)(CH_2SO_2F)CH_2CH=CH_2$,

$CF_2=CFCF_2C(CF_3)(OCH_2OCH_3)CH_2CH=CH_2$,

$CF_2=CFCF_2C(CF_3)(OH)CH=CH_2$,

$CF_2=CFCF_2C(CF_3)(OH)CH_2CH=CH_2$,

$CF_2=CFCF_2C(CF_3)(OCH_2OCH_2CF_3)CH_2CH=CH_2$,

$CF_2=CFCF_2C(CF_3)(OCH_2OCH_3)CH_2CH=CH_2$,

$CF_2=CFOCF_2CF(O(CF_2)_3OCH_5)CH_2CH=CH_2$,

$CF_2=CFOCF_2CF(OCF_2CF_2CH_2NH_2)CH_2CH=CH_2$,

$CF_2=CFOCF_2CF(O(CF_2)_3CN)CH=CH_2$,

$CF_2=CFOCF_2CF(OCF_2CF_2SO_2F)CH_2CH=CH_2$,

$CF_2=CFOCF_2CF(O(CF_2)_3PO(OC_2H_5)_2)CH_2CH=CH_2$,

$CF_2=CFOCF_2CF(OCF_2CF_2SO_2F)CH_2CH=CH_2$.

In monomer (2), n is preferably 1 or 2. X is preferably a hydrogen atom or a methyl group. $R^F$ preferably contains from 4 to 24 carbon atoms.

When n is 1, $R^F$ is a monovalent fluorine-containing organic group. The monovalent fluorine-containing organic group is preferably a monovalent fluorine-containing organic group having a polyfluoroalkyl group wherein an ether type oxygen atom may be inserted between carbon atoms. Such a monovalent fluorine-containing organic group is preferably a group represented by $-(CH_2)_{f1}R^{F1}$, $-SO_2NR^4(CH_2)_{f1}R^{F1}$ or $-(C=O)NR^4(CH_2)_{f1}R^{F1}$. Here, f1 represents an integer of from 1 to 3, $R^{F1}$ represents a polyfluoroalkyl group containing from 4 to 16 carbon atoms and wherein an ether type oxygen atom may be inserted between carbon atoms, $R^4$ represents a hydrogen atom, a methyl group or a ethyl group. $R^{F1}$ is preferably perfluoroalkyl group, particularly preferably a linear perfluoroalkyl group.

When n is 2, $R^F$ is a divalent fluorine-containing organic group. The divalent fluorine-containing organic group is preferably a polyfluoroalkylene group wherein an ether type oxygen atom is inserted between carbon atoms, particularly preferably a group represented by $-(CH_2)_{f2}R^{F2}(CH_2)_{f3}-$. Here, f2 and f3 each represents an integer of from 1 to 3, $R^{F2}$ represents a polyfluoroalkylene group containing from 4 to 16 carbon atoms and wherein an ether type oxygen atom is inserted between carbon atoms. $R^{F2}$ is preferably a perfluoroalkylene group, particularly preferably a linear perfluoroalkylene group or a perfluorooxyalkylene group wherein an ether type oxygen atom is inserted between carbon atoms and which has a trifluoromethyl group as its side chain.

As specific examples of monomer (2), the following compounds are mentioned:

$CH_2=CHCOO(CH_2)_2(CF_2)_8F$,

$CH_2=CHCOO(CH_2)_2(CF_2)_6F$,

$CH_2=C(CH_3)COO(CH_2)_2(CF_2)_8F$,

$CH_2=C(CH_3)COO(CH_2)_2(CF_2)_6F$,

$CH_2=CHCOOCH_2(CF_2)_7F$,

$CH_2=C(CH_3)COOCH_2(CF_2)_7F$,

$CH_2=CHCOOCH_2CF_2CF_2H$,

$CH_2=CHCOOCH_2(CF_2CF_2)_4H$,

$CH_2=C(CH_3)COOCH_2CF_2CF_2H$,

$CH_2=C(CH_3)COOCH_2(CF_2CF_2)_4H$,

$CH_2=CHCOOCH_2CF_2OCF_2CF_2OCF_3$,

$CH_2=CHCOOCH_2CF_2O(CF_2CF_2O)_3CF_3$,

$CH_2=C(CH_3)COOCH_2CF_2OCF_2CF_2OCF_3$,

$CH_2=C(CH_3)COOCH_2CF_2O(CF_2CF_2O)_3CF_3$,

$CH_2=CHCOOCH_2CF(CF_3)O(CF_2CF(CF_3)O)_2(CF_2)_3F$,

$CH_2=C(CH_3)COOCH_2CF(CF_3)O(CF_2CF(CF_3)O)_2(CF_2)_3F$,

$CH_2=CHCOOCH_2CF_2O(CF_2CF_2O)_6CF_2CH_2OCOCH=CH_2$,

$CH_2=C(CH_3)COOCH_2CF_2O(CF_2CF_2O)_6CF_2CH_2OCOC(CH_3)=CH_2$,

$CH_2=CHCOOCH_2(CF_2)_4CH_2OCOCH=CH_2$,

$CH_2=C(CH_3)COOCH_2(CF_2)_4CH_2OCOC(CH_3)=CH_2$.

The photocurable composition contains a fluorine-containing surfactant and/or a fluorine-containing polymer in an amount of from more than 0.1 to 20 mass%, preferably from 0.5 to 10 mass%, particularly preferably from 1 to 5 mass%. When the content is in this range, it becomes easy to prepare the photocurable composition and to make the composition form a cured product without undergoing phase separation.

The photocurable composition may contain a fluorine-containing surfactant and a fluorine-containing polymer, and the composition may contain only a fluorine-containing surfactant or it may contain only a fluorine-containing monomer. Here, when the photocurable composition contains both of the fluorine-containing surfactant and a fluorine-containing polymer, the content means the total content of the fluorine-containing surfactant and the fluorine-containing polymer.

One type of the fluorine-containing surfactant may be used alone or at least two types of the fluorine-containing surfactants may be used in combination. One type of the fluorine-containing polymer may be used alone or at lest two types of the fluorine-containing polymer may be used in combination.

When the photocurable composition contains a fluorine-containing surfactant, a cured product of the photocurable composition is excellent in mold-separation property, and the product can be smoothly separated from a mold.

The fluorine content of the fluorine-containing surfactant is preferably from 10 to 70 mass%, more preferably from 20 to 40 mass%. The fluorine-containing surfactant may be of water-soluble type or a fat-soluble type.

The fluorine-containing surfactant is preferably an anionic fluorine-containing surfactant, a cationic fluorine-containing surfactant, an amphoteric fluorine-containing surfactant or a nonionic fluorine-containing surfactant, and from the viewpoint of good dispersibility, it is particularly preferably a nonionic fluorine-containing surfactant.

The anionic fluorine-containing surfactant is preferably a polyfluoroalkyl carboxylate, a polyfluoroalkyl phosphoric acid ester or a polyfluoroalkyl sulfonate. A specific example of the anionic fluorine-containing surfactant may, for example, be Surflon S-111 (product name, manufactured by AGC SEIMI CHEMICAL CO., LTD.), Fluorad FC-143 (product name, manufactured by 3M), Megaface F-120 (product name, manufactured by DIC Corporation).

The cationic fluorine-containing surfactant is preferably trimethylammonium salt of polyfluoroalkyl carboxylic acid or a trimethylammonium salt of polyfluoroalkyl sulfonic acid. A specific example of the cationic fluorine-containing surfactant may, for example, be Surflon S-121 (product name, manufactured by AGC SEIMI CHEMICAL CO., LTD.), Fluorad FC-134 (product name, manufactured by 3M), Megaface F-450 (product name, manufactured by DIC Corporation), etc.

The amphoteric fluorine-containing surfactant is preferably a polyfluoroalkyl betaine. A specific example of the amphoteric fluorine-containing surfactant may, for example, be Surflon S-132 (product name, manufactured by AGC SEIMI CHEMICAL CO., LTD.), Fluorad FX-172 (product name, manufactured by 3M), etc.

The nonionic fluorine-containing surfactant may, for example, be a polyfluoroalkylamine oxide, a polyfluoroalkyl·alkylene oxide adduct, an oligomer or a polymer containing a monomer unit based on a monomer having a fluoroalkyl group, etc. The fluoroalkyl group is preferably the above-mentioned polyfluoroalkyl group ($R^{F1}$).

The nonionic fluorine-containing surfactant is preferably an oligomer or a polymer containing a monomer unit based on a monomer having a fluoroalkyl group, and its mass-average molecular weight is preferably from 1,000 to 8,000. The monomer having a fluoroalkyl group is preferably a fluoro(meth)acrylate, particularly preferably a fluoroalkyl (meth)acrylate. The fluoroalkyl (meth)acrylate is preferably a compound that is monomer (2) wherein n is 1 and X is a hydrogen atom or a methyl group.

A specific example of the nonionic fluorine-containing surfactant may, for example, be Surflon S-145 (product name, manufactured by AGC SEIMI CHEMICAL CO., LTD.), Surflon S-393 (product name, manufactured by AGC SEIMI CHEMICAL CO., LTD.), Surflon KH-20 (product name, manufactured by AGC SEIMI CHEMICAL CO., LTD.), Surflon KH-40 (product name, manufactured by AGC SEIMI CHEMICAL CO., LTD.), Fluorad FC-170 (product name, manufactured by 3M), Fluorad FC-430 (product name, manufactured by 3M), Megaface F-444 (product name, manufactured by DIC Corporation), Megaface F-479 (product name, manufactured by DIC Corporation) etc.

When the photocurable composition contains a fluorine-containing polymer, a cured product of the photocurable composition is excellent in mold-separation property and it can be smoothly separated from a mold. Further, since polymerization of monomer undergoes with presence of the fluorine-containing polymer at a time of curing the photocurable composition, a cured product showing little volume shrinkage rate can be obtained. For this reason, the shape of ridges formed on a surface of the cured product is precisely equal to the shape of the grooves of a mold. Here, the fluorine-containing polymer means one other than the oligomer or polymer containing a monomer unit based on a monomer having a fluoroalkyl group mentioned as the nonionic fluorine-containing surfactant.

The mass-average molecular weight of the fluorine-containing polymer is, from the viewpoint of compatibility with other components, preferably from 500 to 100,000, more preferably from 1,000 to 100,000, particularly preferably from 3,000 to 50,000.

The fluorine content of the fluorine-containing polymer is, from the viewpoint of excellent mold separation property, preferably from 30 to 70 mass%, more preferably from 45 to 70 mass%.

The fluorine-containing polymer is, from the viewpoint of compatibility, preferably a fluorine-containing polymer containing a heteroatom, more preferably a fluorine-containing polymer containing a nitrogen atom, an oxygen atom, a sulfur atom or a phosphorus atom, particularly preferably a fluorine-containing polymer containing a hydroxyl group, an ether type oxygen atom, an ester group, an alkoxy carbonyl group, a sulfonyl group, a phosphoric acid ester group, an amino group, a nitro group or a ketone group.

The fluorine-containing polymer may, for example, be a fluorine-containing polymer obtained by polymerizing monomer (1), or a fluorine-containing polymer obtained by copolymerizing $CF_2=CF_2$ and $CH_2=CHOCOCH_3$.

The fluorine-containing polymer is preferably the fluorine-containing polymer obtained by polymerizing monomer (1), particularly preferably the polymer wherein $R^1$ is a fluorine atom, $R^2$ is a hydrogen atom and Q is a group selected from the group consisting of $-CF_2C(CF_3)(OH)CH_2-$, $-CF_2C(CF_3)(OH)-$, $-CF_2C(CF_3)(OCH_2OCH_3)CH_2-$, $-CH_2CH(CH_2C(CF_3)_2OH)CH_2-$ and $-CH_2CH(CH_2C(CF_3)_2OH)-$.

In the photocurable composition, the amount of fluorine-containing monomer based on the total amount of the fluorine-containing surfactant and the fluorine-containing polymer, is preferably from 1 to 100 times mass, more preferably from 1 to 20 times mass, particularly preferably from 1 to 10 times mass.

The photocurable composition contains the photopolymerization initiator in an amount of from 1 to 10 mass%, preferably from 2 to 9 mass%, particularly preferably from 3 to 8 mass%. When the content is within this range, it becomes possible to easily polymerize a monomer in the photocurable composition to form a cured product, and accordingly, it is not necessary to carry out an operation such as heating.

Further, it is not likely that residue photopolymerization initiator affects physical property of the cured product.

The photopolymerization initiator is a compound undergoing a radical reaction or an ion reaction by light.

The photopolymerization initiator may be the following photopolymerization initiator.

Acetophenone type photopolymerization initiator: acetophenone, p-(tert-butyl)-1',1',1'-trichloroacetophenone, chloroacetophenone, 2',2'-diethoxyacetophenone, hydroxyacetophenone, 2,2-dimethoxy-2'-phenylacetophenone, 2-aminoacetophenone, dialkylaminoacetophenone, etc.

Benzophenone type photopolymerization initiator: benzyl, benzoin, benzoin methyl ether, benzoin ethyl ether, benzoin isopropyl ether, benzoin isobutyl ether, 1-hydroxycyclohexyl phenyl ketone, 2-hydroxy-2-methyl-1-phenyl-2-methylpropane-1-on, 1-(4-isopropylphenyl)-2-hydroxy-2-methylpropane-1-on, benzyl dimethyl ketal, etc.

Benzophenone type photopolymerization initiator: benzophenone, benzoyl benzoic acid, benzoyl methyl benzoate, methyl-o-benzoyl benzoate, 4-phenylbenzophenone, hydroxybenzophenone, hydroxypropylbenzophenone, acrylbenzophenone, 4,4'-bis(dimethylamino)benzophenone.

Thioxanthone type photopolymerization initiator: thioxanthone, 2-chlorothioxanthone, 2-methylthioxanthone, diethylthioxanthone, dimethylthioxanthone, etc.

Photopolymerization initiator containing fluorine atom: perfluoro(tert-butyl peroxide), perfluorobenzoyl peroxide, etc.

Other photopolymerization initiators: $\alpha$-acyloxime ester, benzyl-(o-ethoxycarbonyl)-$\alpha$-monooxime, acylphosphineoxide, glyoxyester, 3-ketocoumarin, 2-ethylanthraquinone, camphorquinone, tetramethylthiuram sulfide, azobisisobutyronitrile, benzoyl peroxide, dialkyl peroxide, tert-butyl peroxypivalate, etc.

The photocurable composition contains substantially no solvent. Since the photocurable composition contains a fluorine-containing monomer having high compatibility with a specific main component monomer, the fluorine-containing surfactant and the fluorine-containing polymer, it is possible to form a uniform composition even without containing a solvent. Since it contains no solvent, curing is possible without carrying out other steps (e.g. distillation step for removing solvent). Further, the photocurable composition shows small volume shrinkage when it is cured. Containing substantially no solvent means containing no solvent or a state that solvent employed for photocurable composition is removed as much as possible.

The photocurable composition may contain a component (hereinafter referred to as another component) other than the main component monomer, the fluorine-containing monomer, the fluorine-containing surfactant, the fluorine-containing polymer and the photopolymerization initiator. Said another component may, for example, be a photosensitizer, an inorganic material, a carbon material, an electrically conductive polymer, a colorant such as phthalocyanine, an organic metal coordinate such as porphyrin, an organic magnetic material, an organic semiconductor or a liquid crystal material, etc.

A specific example of the photosensitizer may, for example, be n-butylamine, di-n-butylamine, tri-n-butylphosphine, allylthiourea, s-benzylisothiuronium-p-toluene sulfinate, triethylamine, diethylaminoethyl methacylate, triethylenetetramine, 4,4'-bis(dialkylamino)benzophenone, etc.

A specific example of the inorganic material may, for example, be a silicon compound (silicon, silicon carbide, silicon dioxide, silicon nitride, silicon germanium, iron silicide, etc.), metal (platinum, gold, rhodium, nickel, silver, titan, lanthanide type element, copper, iron, zinc, etc.), a metal oxide (titanium oxide, alumina, lead oxide, ITO, iron oxide,

copper oxide, bismuth oxide, manganese oxide, hafnium oxide, yttrium oxide, tin oxide, cobalt oxide, cerium oxide, silver oxide, etc.), inorganic compound salt (a ferrodielectric material such as barium titanate, a piezoelectric material such as lead zirconate titanate, a battery material such as a lithium salt, etc.), a metal alloy (a magnetic material such as a ferrite type magnet or a neodyum type magnet, a semiconductor such as a bismuth-tellur alloy or a gallium-arsenium alloy, a fluorescence material such as gallium nitride, etc.) etc.

A specific example of the carbon material may, for example, be fullerene, carbon nanotube, carbon nanohorn, graphite, diamond, activated carbon, etc.

FINE METALIC WIRE

Fine metalic wires are formed only on ridges, and substantially no fine metalic wire is formed in grooves between the ridges. Since the fine metalic wires are formed only on the ridges, the refractive index of a light-transmitting substrate becomes not the refractive index of the photocured resin in the ridges concealed by the fine metalic wires, but the refractive index of air present in the grooves between the ridges. Accordingly, the maximum wavelength of Reyleigh resonance becomes shorter than that of a conventional wire-grid polarizer, and polarization separation ability in shorter wavelength side improves.

The material of fine metalic wires is, from the viewpoints of high reflectivity for visible light, low absorption of visible light and high dielectric constant, preferably silver, aluminum, chromium, magnesium or platinum, particularly preferably aluminum.

The cross sectional shape of the fine metalic wires may be a square, a rectangle, a trapezoid, a circle, a ellipse or other various shapes.

The fine metalic wires have very small thickness and width, and the performance of wire-grid polarizer is deteriorated by a slight damage of the fine metalic wires. Further, rust of the fine metalic wires decreases their electrical conductivity, and deteriorates the performance of the wire-grid polarizer. Accordingly, in order to prevent damage and rust of the fine metalic wires, the fine metalic wires may be covered by a protection layer.

The protection layer may be a resin, a metal oxide, a glass, etc. For example, when aluminum as a metal is employed, it is oxidized in the air to form aluminum oxide on a surface. A metal oxide film functions as a protection layer for the fine metalic wires.

In order to reduce reflection of P-polarized light at an interface between the substrate and the protection layer, it is preferred to make the refractive indexes of the protection layer and the light-transmitting substrate substantially equal to each other.

The protection layer is preferably one having heat resistance and visible light transmittance, and for the reason that high polarization separation ability is obtainable in wide range, the protection layer is more preferably one having low refractive index.

Since the protection layer is present at the outermost surface of a wire-grid polarizer, the protection layer is preferably one having a hardness of at least pencil hardness H, and preferably one having antifouling property.

In order to improve light utilization efficiency, the protection layer or the light-transmitting substrate may have an antireflective structure on its surface.

The wire-grid polarizer of the present invention described above has a light-transmitting substrate having a surface on which a plurality of parallel ridges are formed at a constant pitch, and fine metalic wires formed on the ridges of the light-transmitting substrate, and accordingly, the polarizer shows high polarization separation ability in visible light region. Further, since the light-transmitting substrate is made of a photocured resin, it is excellent in heat resistance and durability.

PROCESS FOR PRODUCING WIRE-GRID POLARIZER

The wire-grid polarizer of the present invention is produced by a process having the following steps (a) to (f).

(a) A step of coating a supporting substrate with a photocurable composition.
(b) A step of pressing a mold on which a plurality of parallel grooves are formed at a constant pitch against the photocurable composition so that the grooves contacts with the photocurable composition.
(c) A step of curing the photocurable composition in a state that the mold is pressed against the photocurable composition, to form a light-transmitting substrate having a plurality of ridges corresponding to the grooves of the mold.
(d) A step of separating the mold from the light-transmitting substrate.
(e) A step of forming fine metalic wires on the ridges of the light-transmitting substrate.
(f) A step of separating the supporting substrate from the light-transmitting substrate as the case requires.

(STEP (a))

As shown in Fig. 2(a), a supporting substrate 22 is coated with a photocurable composition 20.

The photocurable composition 20 is preferably the above-mentioned photocurable composition.

The material of the supporting substrate 22 may, for example, be an inorganic material such as quartz, a glass or a metal; or a resin material such as polydimethylsiloxane or a transparent fluororesin.

The coating method may, for example, be a potting method, a spin coating method, a roll coating method, a die coating method, a spray coating method, a cast method, a dip coating method, a screen printing or a transcripting method.

(STEP (b))

As shown in Fig. 2(b), a mold 26 on which a plurality of parallel grooves 24 is formed at a constant pitch, is pressed against a photocurable composition 20 so that the grooves 24 contact with the photocurable composition 20. Here, a constant pitch in the present invention means a constant pitch within a predetermined range, and for example, the pitch in the central portion and the pitch in the peripheral portion may be different so that the characteristic may change depending on the portion.

Fig. 4 is an oblique view of the mold 26. The pitch Pp of the grooves 24 is the total of the width Dp of a groove 24 and the width of a ridge formed between grooves 24. The pitch Pp of the grooves 24 is preferably at most 300 nm, more preferably from 50 to 200 nm. By making the pitch Pp at most 300 nm, the wire-grid polarizer shows sufficiently high reflectivity, and even in a short wavelength region of about 400 nm, it shows a high polarization separation ability. Further, coloring due to diffraction can be suppressed.

The ratio (Dp/Pp) of the width Dp of the groove 24 and the pitch Pp is preferably from 0.1 to 0.6, more preferably from 0.4 to 0.55. When Dp/Pp is at least 0.1, the wire-grid polarizer shows sufficiently high polarization separation ability. When Dp/Pp is at most 0.6, coloring due to interference of transmission light can be suppressed.

The depth Hp of the groove 24 is preferably from 50 to 500 nm, more preferably from 100 to 300 nm. When the depth Hp is at least 50 nm, it becomes easy to selectively form fine metalic wires on the transcripted ridges. When the depth Hp is at most 500 nm, incident angle dependence of the polarization degree of the wire-grid polarizer becomes small.

The material of the mold 26 is preferably a light-transmitting material such as quartz, a glass, polydimethylsiloxane or a transparent fluororesin. Further, when a transparent supporting substrate is employed, a non-transmitting mold such as silicon or nickel may also be employed.

By making the shape of the mold a roll shape, it becomes possible to press the mold against the photocurable composition while the roll shaped mold is rotated, and cure the photocurable composition to continuously transcript ridges corresponding to the grooves, whereby it becomes possible to produce a large area wire-grid polarizer.

The pressure (gauge pressure) at the time of pressing the mold 26 against the photocurable composition 20 is preferably more than 0 and at most 10 MPa.

(STEP (c))

As shown in Fig. 2(c), in a state that the mold 26 is pressed against the photocurable composition 20, the photocurable composition 20 is cured to produce a light-transmitting substrate 14 having a plurality of ridges 12 corresponding to the grooves 24 of the mold 26.

Curing is, when the mold is made of a light-transmitting material, carried out by irradiating the photocurable composition 20 with light from the mold 26 side. When the supporting substrate 20 is made of a light-transmitting material, the photocurable composition 20 may be irradiated with light from the supporting substrate 22 side. Further, curing by heating may be used in combination.

As a light source for irradiating light, e.g. a high pressure mercury lamp is employed.

(STEP (d))

As shown in Fig. 3(d), the mold 26 is separated from the light-transmitting substrate 14. Here, before the step (d), a step (f) of separating the supporting substrate 22 may be carried out.

(STEP (e))

As shown in Fig. 3(e), fine metalic wires 16 are formed on the ridges 12 of the light-transmitting substrate 14. Here, before the step (e), a step (f) of separating the supporting substrate 22 may be carried out.

The method for forming the fine metalic wires 16 may, for example, be a vapor deposition method, a sputtering method or a plating method, and from the viewpoint of selectively forming the fine metalic wires 16 on the ridges 12, an oblique deposition method (including an oblique sputtering method) of forming a film by making fine particles incident in an oblique direction in vacuum. When the pitch is narrow and the height of ridges is high like the present invention, by carrying out an oblique deposition at a sufficiently low angle, it is possible to form a metal layer selectively on the ridges 12. Further, by forming a thin metal layer by the oblique deposition method, and subsequently overlaying another metal layer by a plating method, it is also possible to form fine metalic wires having a desired thickness.

(STEP (f))

As shown in Fig. 3(f), the supporting substrate 22 is separated from the light-transmitting substrate 14, to obtain a wire-grid polarizer 10.

Here, when the supporting substrate 22 is made of a light-transmitting material, it is not necessary to separate the supporting substrate 22, and a wire-grid polarizer in which the light-transmitting substrate 14 and the supporting substrate 22 are integrated, may be employed as the polarizer.

The process for producing a wire-grid polarizer of the present invention described above, is a process comprising the steps (a) to (f), namely, a photo imprint method, and accordingly, as compared with a conventional lithography method, the process has less production steps, the process enables to produce a wire-grid polarizer with high productivity, and enables to produce a wire-grid polarizer of large area. Further, since a photo imprint method employs a photocurable composition, differently from a conventional thermal imprint method employing a thermoplastic resin for a substrate, the photo imprint method enables to produce a wire-grid polarizer excellent in heat resistance and durability.

EXAMPLES

From now, the present invention will be described in further detail with reference to Examples, but the present invention is not limited to these Examples.

EXAMPLE 1

Fig. 5 and Fig. 6 show the transmittances of P-polarized light and S-polarized light vs. incident light wavelength, and the polarization degree of transmission light vs. incident light wavelength of the wire-grid polarizer of the present invention, that is calculated by a three-dimensional electric field simulation software "MW Studio" (CST Gmb Corporation).

Calculation was made with respect to a wire-grid polarizer having a light-transmitting substrate of refractive index (nd) of 1.5 under the conditions that light is incident into the wire-grid polarizer from the fine metalic wire side, the incident angle $\theta = 0^\circ$ or $45^\circ$, the pitch Pp = 200 nm, the width of fine metalic wires Dm = 100 nm, and the height of fine metalic wires Hm = 100 nm.

As the material of fine metalic wires, aluminum having high electrical conductivity and high reflectivity for visible light was selected. The polarization degree was calculated based on the following formula.

Polarization degree = $((Tp - Ts)/(Tp + Ts))^{0.5}$ wherein Tp represents the transmittance for P-polarized light and Ts represents the transmittance for S-polarized light.

Fig. 5 indicates that the polarization degree of transmission light of visible light exceeds 95% at an incident angle $\theta = 0^\circ$, and the polarizer has a good polarization separation ability.

Fig. 6 shows the polarization degree at an incident angle $\theta = 45^\circ$. It is known that as the incident angle increases, the maximum resonation wavelength increases, but the wire-grid polarizer of the present invention shows sufficiently high polarization separation ability in the visible light region when the refractive index (nd) is 1.5.

EXAMPLE 2

PREPARATION OF PHOTOCURABLE COMPOSITION

In a vial container (capacity 6 mL), 0.30 g of monomer (3-1), 0.40 g of monomer (3-2), 0.25 g of monomer (2-1), 0.01 g of a fluorine-containing surfactant (manufactured by Asahi Glass Company, Limited), cooligomer (fluorine content about 30 mass%, weight average molecular weight about 3,000) of fluoroacrylate ($CH_2=CHCOO(CH_2)_2(CF_2)_8F$), and 0.04 g of a photopolymerization initiator (manufactured by Ciba Specialty Chemicals Inc., Irgacure 907) were added, and they were blended to prepare a photocurable composition (hereinafter referred to as composition 1) having a viscosity of 12 mPa·s.

A cured product of the composition 1 has a refractive index (nd) of 1.48, a visible light transmittance of 94.2% when the thickness is 200 μm, a contact angle with water of 95° and a Vicat softening temperature of 154°C.

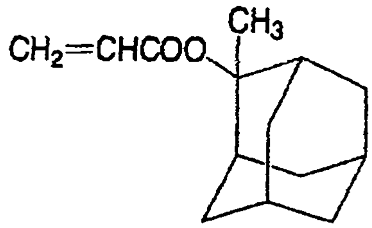

(3-1)

$CH_2=CHCOO(CH_2CH_2O)_4COCH=CH_2$ (3-2)

$CH_2=CHCOOCH_2CH_2(CF_2)_6F$ (2-1)

PREPARATION OF WIRE-GRID POLARIZER

A quartz substrate of 2.8 mm thick was coated with the composition 1 by a spin coating method to form a coating film of the composition 1 of 1 μm thick.

A transparent mold (groove pitch Pp = 200 nm, grid width Dp = 100 nm, groove depth Hp = 150 nm) made of quartz on which a plurality of grooves were formed by electron beam fabrication, was pressed against the film of the composition 1 at 25˚C at 0.5 MPa (gauge pressure) so that the grooves were contact with the film of composition 1.

While the above state is maintained, the composition 1 was irradiated with light of a high pressure mercury lamp (frequency = 1.5 kHz to 2.0 kHz, main wavelengths = 255 nm, 315 nm and 365 nm, radiation energy at 365 nm = 1,000 mJ) from the transparent mold side for 15 seconds to cure the composition 1, to cure the composition 1, to form a light-transmitting substrate having a plurality of ridges (pitch Pp = 200 nm, width Dp = 100 nm, height Hp = 150 nm) corresponding to the grooves of the transparent mold.

The transparent mold was slowly separated from the light-transmitting substrate.

On the ridges of the light-transmitting substrate, aluminum was vapor deposited by an oblique deposition method, to form fine metalic wires (thickness Hm = 150 nm, width Dm = 100 nm), to obtain a wire-grid polarizer in which the light-transmitting substrate and the quartz substrate were integrated.

EXAMPLE 3 (COMPARATIVE EXAMPLE)

PREPARATION OF WIRE-GRID POLARIZER

A quartz substrate of 2.8 mm thick was coated with a polyethylene terephthalate (PET) solution by a spin coating method, and it was dried to form a PET film of 1 μm thick.

The same transparent mold as that of Example 2 was heated to 150˚C, and the transparent mold of 150˚C was pressed against the PET film at 10 MPa (gauge pressure) so that the grooves of the mold contact with the PET film, to produce a light-transmitting substrate having a plurality of ridges (pitch Pp = 200 nm, width Dp = 100 nm, height Hp = 150 nm) corresponding to the grooves of the transparent mold.

The transparent mold was cooled to 30˚C, and it was separated slowly from the light-transmitting substrate.

On the ridges of the light-transmitting substrate, aluminum is vapor deposited by an oblique deposition method, to form fine metalic wires (thickness Hm = 150 nm, width Dm = 100 nm) to obtain a wire-grid polarizer in which the light-transmitting substrate and a quartz substrate were integrated.

EVALUATION

PRODUCTIVITY

With respect to productivity, when production time per a polarizer is less than 2 minutes, it was evaluated as ○, and when production time per a polarizer is at least 2 minutes, it was evaluated as ×. Table 1 shows the results.

MOLD-SEPARATION PROPERTY

With respect to mold-separation property, when elongation was less than 5% in a longitudinal direction, it was

evaluated as ○; when elongation in a longitudinal direction was at least 5% and less than 10%, it was evaluated as Δ; and when elongation in a longitudinal direction was at least 10%, it was evaluated as ×. Table 1 shows the results.

TRANSMITTANCE

A laser beam of wavelength 405 nm from a solid state laser and a laser beam of wavelength 635 nm from a semiconductor laser were incident perpendicularly into a fine metalic wire side of the wire-grid polarizer, and transmittances for P-polarized light and S-polarized light were measured.

When the transmittance was at least 70%, it was evaluated as ○, and when the transmittance was less than 70%, it was evaluated as ×. Table 1 shows the results.

POLARIZATION DEGREE

The polarization degree was calculated according to the following formula.

$$\text{Polarization degree} = ((Tp - Ts)/(Tp + Ts))^{0.5}$$

Here, Tp represents the transmittance of P polarized light, and Ts represents the transmittance of S polarized light.

When the polarized degree was at least 90%, it was evaluated as ○, and when the polarization degree was less than 90%, it was evaluated as ×. Table 1 shows the results.

HEAT RESISTANCE

The wire-grid polarizer was left in an atmosphere of 200°C for 1,000 hours, to prepare a heat resistance test sample. With respect to the heat resistance test sample, transmittance was measured in the same manner as described above, and calculated the polarization degree.

When the change of transmittance between before and after the heat resistance test was less than 1%, the sample was evaluated as ○; when the change was at least 1% and less than 5%, it was evaluated as Δ; and when the change was at least 5%, it was evaluated as ×. Further, when the change of polarization degree between before and after the heat resistance test was less than 1%, the sample was evaluated as ○; when the change was at least 1% and less than 5%, it was evaluated as Δ; and when the change was at least 5%, it was evaluated as ×. Table 1 shows the results.

TABLE 1

| | | Example 2 | Example 3 |
|---|---|---|---|
| Productivity | | ○ | × |
| Mold-separation property | | ○ | × |
| Polarization degree | | ○ | ○ |
| Transmittance | | ○ | ○ |
| Heat resistance | Polarization degree | ○ | × |
| | Transmittance | ○ | × |

The thermal imprint method of Example 3 can drastically simplify the process as compared with a conventional lithography method, but its tact time is longer as compared with the photo imprint method of Example 2. Further, the thermal imprint method of Example 3 requires high temperature-high pressure condition and requires a complicated apparatus, and accordingly, the method is not excellent in productivity.

The PET employed in Example 3 shows poor mold-separation property, and it was necessary to apply a mold-separation agent to the transparent mold.

On the other hand, the photocured resin of Example 2 has low surface free energy and showed good mold-separation property without a mold-separation agent.

With respect to polarization degree and transmittance, Examples 2 and 3 showed good results. However, with respect to these evaluations after the heat resistance test, Example 3 showed deterioration of polarization separation

ability due to disturbance of concave-convex pattern. Further, due to yellowing (coloring) of PET, Example 3 showed significant deterioration in transmittance. On the other hand, Example 2 did not show deterioration of performance and showed good heat resistance.

INDUSTRIAL APPLICABILITY

The wire-grid polarizer of the present invention shows high polarization separation ability in the visible light region, and is excellent in heat resistance and durability, and accordingly it is useful as a polarizer for an image display device such as liquid crystal display devices, rear projection TVs or front projectors. Particularly, since it is excellent in heat resistance, it is suitable as a polarizer for rear projection TVs or front projectors.

The entire disclosure of Japanese Patent Application No. 2006-106134 filed on April 7, 2006 including specification, claims, drawings and summary is incorporated herein by reference in its entirety.

## Claims

**1.** A process for producing a wire-grid polarizer, comprising a step of coating a supporting substrate with a photocurable composition, a step of pressing a mold having a plurality of parallel grooves at a constant pitch against the photocurable composition so that the grooves contact with the photocurable composition, a step of curing the photocurable composition in a state that the mold is pressed against the photocurable composition, to form a light-transmitting substrate having a plurality of ridges corresponding to the grooves of the mold, a step of separating the mold from the light-transmitting substrate, and a step of forming fine metalic wires on the ridges of the light-transmitting substrate.

**2.** The process for producing the wire-grid polarizer according to Claim 1, which further comprises a step of separating the supporting substrate from the light-transmitting substrate.

**3.** The process for producing the wire-grid polarizer according to Claim 1 or 2, wherein the photocurable composition is one for producing the following photocured resin having the following physical property after curing:

a photocured resin having a refractive index (nd) of from 1.3 to 1.6, and a visible light transmittance of at least 93% when the thickness is 200 μm.

**4.** The process for producing a wire-grid polarizer according to any one of Claims 1 to 3, wherein the photocurable composition is one for producing the following photocured resin having the following physical property after curing:

a photocured resin having a contact angle of at least 90˚ with water.

**5.** The process for producing a wire-grid polarizer according to any one of Claims 1 to 4, wherein the photocurable composition is one for producing the following photocured resin having the following physical property after curing:

a photocured resin having a Vicat softening temperature of at least 150˚C.

**6.** The process for producing a wire-grid polarizer according to any one of Claims 1 to 5, wherein the photocurable composition is the following photocurable composition:

a photocurable composition containing from 50 to 98 mass% of monomer containing no fluorine atom, from 0.1 to 45 mass% of fluorine-containing monomer, from more than 0.1 to 20 mass% of a fluorine-containing surfactant and/or a fluorine-containing polymer, and from 1 to 10 mass% of a photo-polymerization initiator, which contains substantially no solvent, and which has a viscosity of from 1 to 200 mPa·s at 25˚C.

**7.** The process for producing a wire-grid polarizer according to any one of Claims 1 to 6, wherein the fluorine-containing monomer in the photocurable composition is the fluorine-containing monomer represented by the following formula (1) or formula (2):

$$CF_2=CR^1\text{-}Q\text{-}CR^2=CH_2 \qquad (1)$$

$$(CH_2=CXCOO)_nR^F \qquad (2)$$

wherein in formula (1), $R^1$ and $R^2$ are each independently a hydrogen atom, a fluorine atom, an alkyl group containing 1 to 3 carbon atoms, or a fluoroalkyl group containing from 1 to 3 carbon atoms, and Q is an oxygen atom, a group represented by $-NR^3-$ (wherein $R^3$ is a hydrogen atom, an alkyl group containing 1 to 6 carbon atoms, an alkylcarbonyl group or a tosyl group), or a divalent organic group that may have a functional group; wherein in formula (2), n is an integer of from 1 to 4, X is a hydrogen atom, a fluorine atom, a methyl group or a trifluoromethyl group, and $R^F$ is a n-valent fluorine-containing organic group containing from 1 to 30 carbon atoms.

**8.** The process for producing a wire-grid polarizer according to any one of Claims 1 to 7, which uses an oblique deposition method to form fine metalic wires on the ridges of the light-transmitting substrate.

**9.** The process for producing a wire-grid polarizer according to any one of Claims 1 to 8, wherein the pitch of grooves on the mold is at most 300 nm.

**10.** A wire-grid polarizer produced by the process as defined in any one of Claims 1 to 9.

Fig. 1

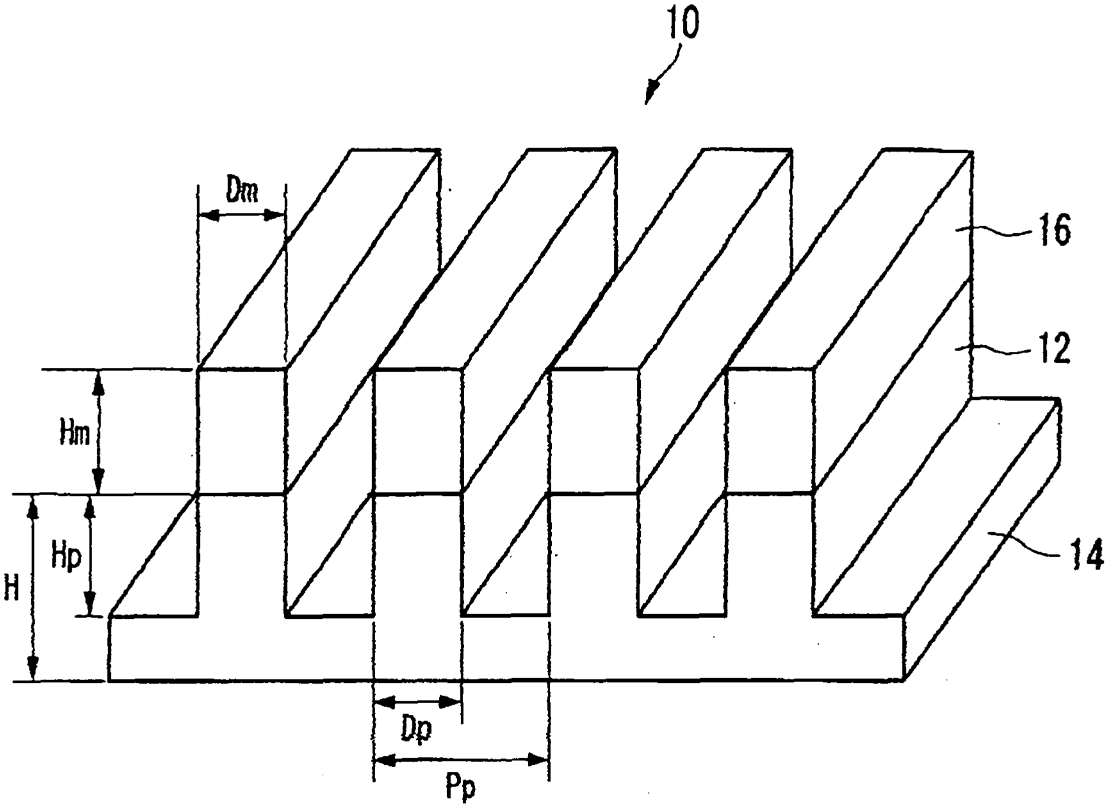

Fig.2(a)

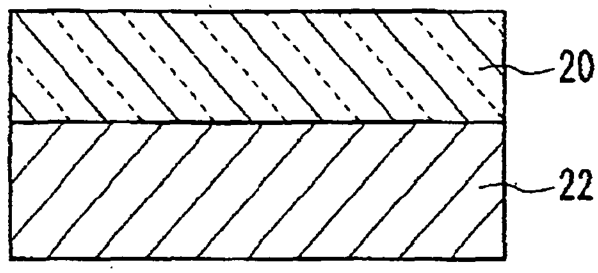


Fig.2(b)

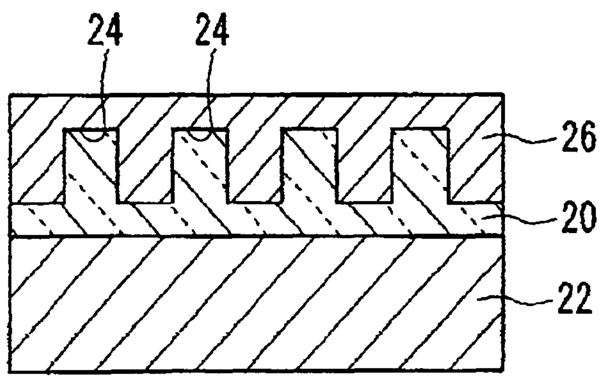


Fig.2(c)

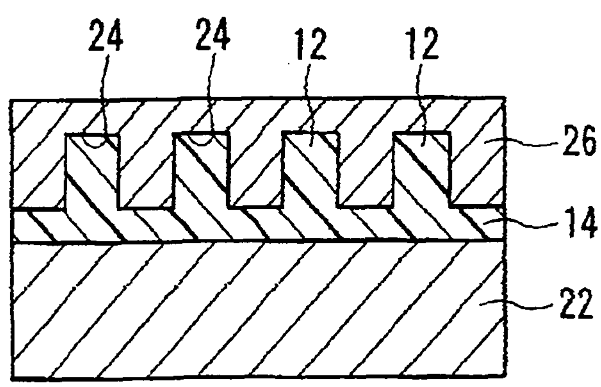

Fig.3(d)

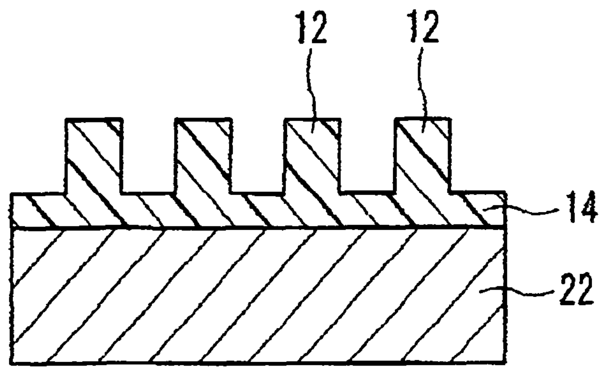


Fig.3(e)

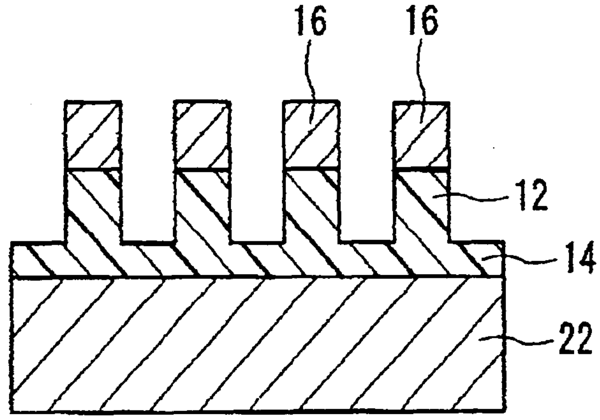


Fig.3(f)

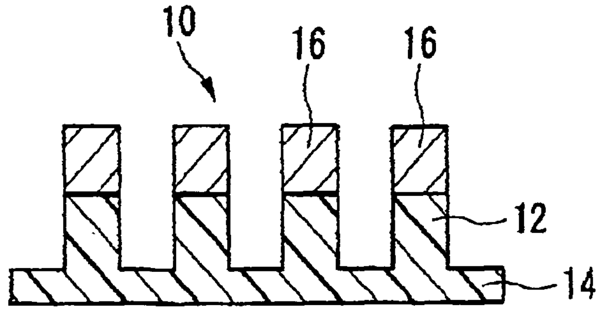

Fig.4

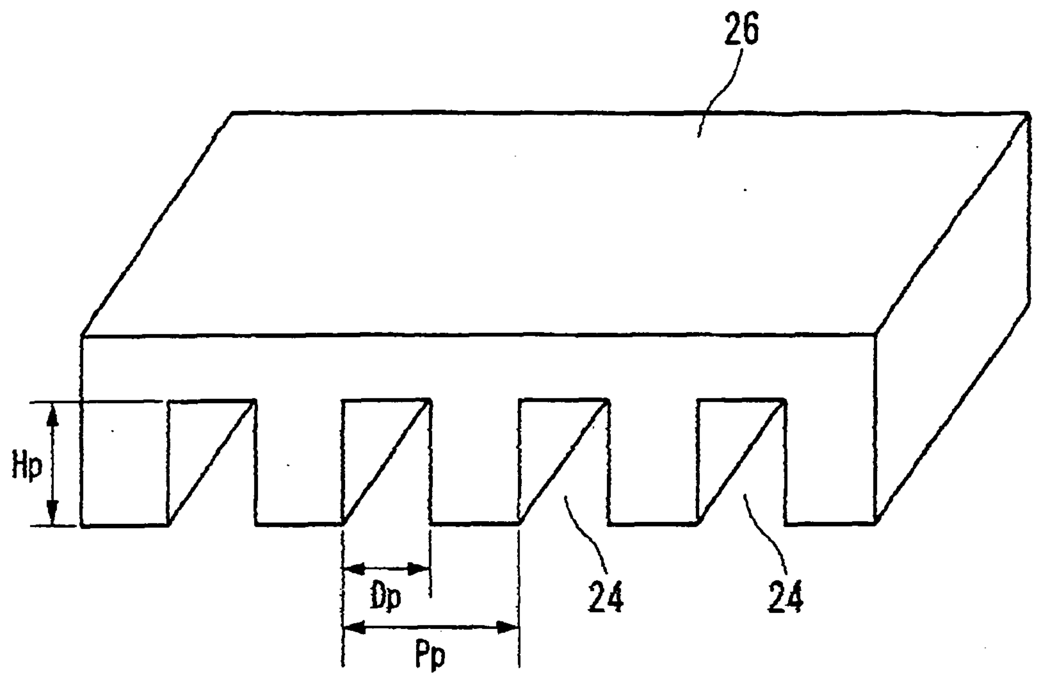

Fig. 5

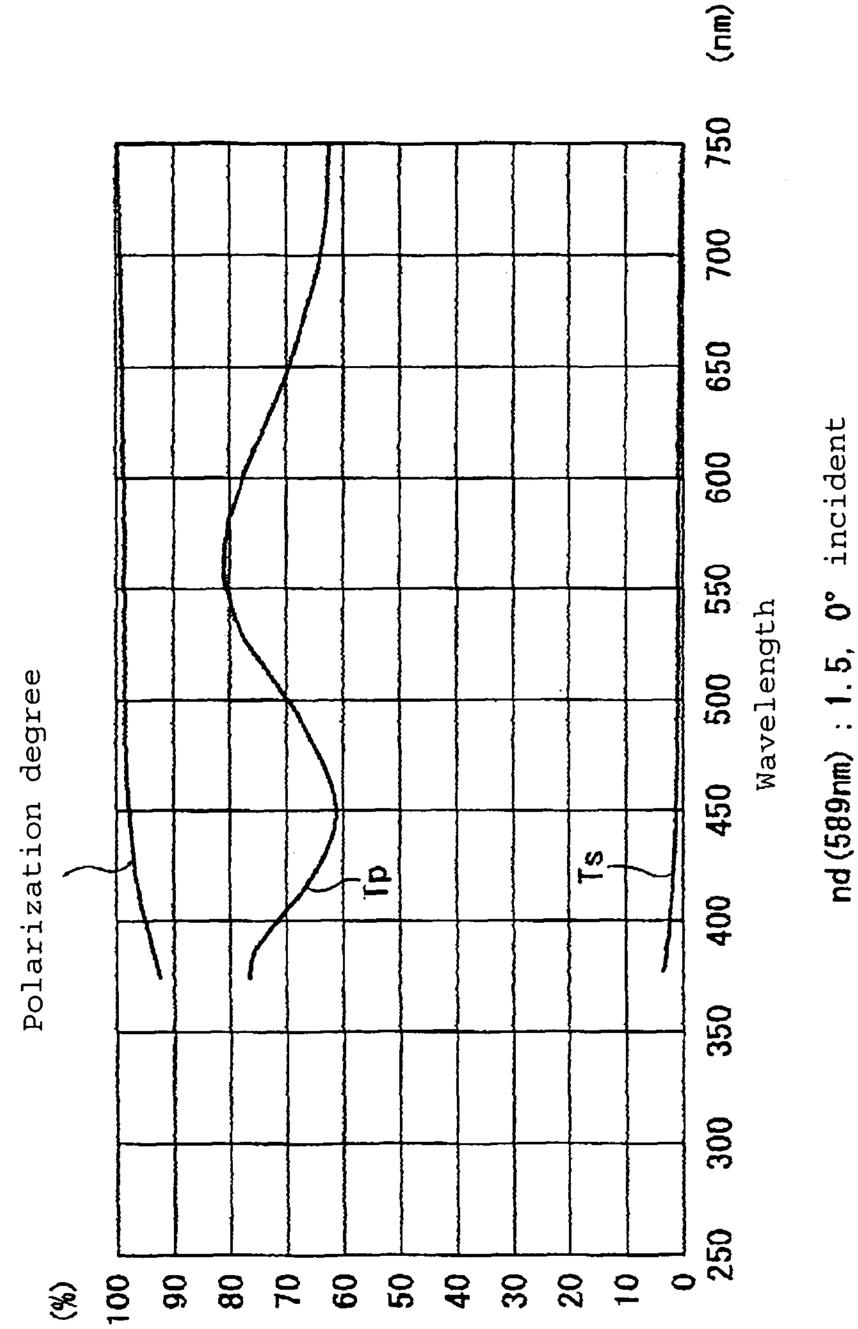
(%)
100
90
80
70
60
50
40
30
20
10
0
250
300
350
400
450
500
550
600
650
700
750
(nm)
Polarization degree
Tp
Ts
Wavelength
nd(589nm) : 1.5, 0° incident

Fig. 6

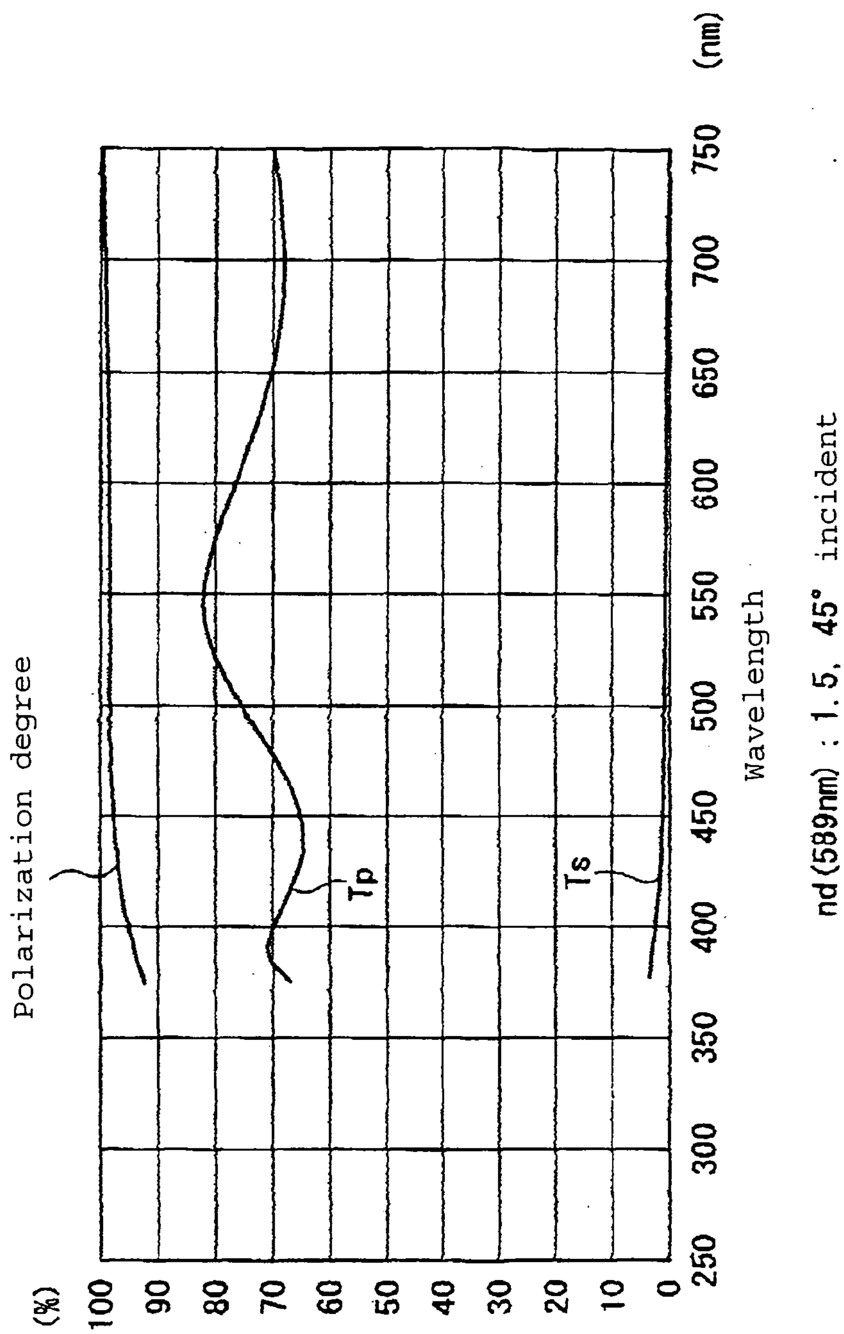
(%)
100
90
80
70
60
50
40
30
20
10
0
250
300
350
400
450
500
550
600
650
700
750
(nm)
Polarization degree
Tp
Ts
Wavelength
nd(589nm) : 1.5, 45° incident

**INTERNATIONAL SEARCH REPORT**

International application No.
PCT/JP2007/057773

A. CLASSIFICATION OF SUBJECT MATTER
*G02B5/30*(2006.01)i, *G02F1/1335*(2006.01)i

According to International Patent Classification (IPC) or to both national classification and IPC

B. FIELDS SEARCHED

Minimum documentation searched (classification system followed by classification symbols)
G02B5/30, G02F1/1335

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2005-181990 A (Nippon Sheet Glass Co., Ltd.),<br>07 July, 2005 (07.07.05),<br>Par. Nos. [0006], [0041], [0059], [0060];<br>Figs. 1, 5, 6<br>& US 2005-122588 A1 | 1-5,8-10<br>6-10 |
| Y | WO 2006/030625 A1 (Asahi Glass Co., Ltd.),<br>23 March, 2006 (23.03.06),<br>Par. Nos. [0010] to [0024], [0028] to [0034]<br>(Family: none) | 6-10 |
| Y | WO 2006/114958 A1 (Asahi Glass Co., Ltd.),<br>22 March, 2006 (22.03.06),<br>Par. Nos. [0007] to [0009], [0017] to [0028]<br>(Family: none) | 6-10 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 June, 2007 (22.06.07) | 03 July, 2007 (03.07.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2007/057773

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-141840 A (Sanyo Electric Co., Ltd.), 02 June, 2005 (02.06.05), Par. No. [0035]; Fig. 2 (Family: none) | 1-10 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 00079317 A
- JP 2005195824 A
- JP 2005316495 A
- JP 2005070456 A
- JP 2006106134 A